# EUROPEAN PATENT APPLICATION

(11) **EP 0 566 262 A2**
(43) Date of publication of application: **20.10.1993**
(21) Application number: 93302327.7
(22) Date of filing: 25.03.1993
(51) Int. Cl.: H01L 29/784, H01L 29/08, H01L 29/10

(54) **Field effect transistor with a deep P body contacted by the source electrode**

(30) Priority: 15.04.1992 US 870127
(71) Applicant: NATIONAL SEMICONDUCTOR CORPORATION, Santa Clara, California 95052-8090 (US)
(72) Inventor: Wrathall, Robert S., Scotts Valley, California 95066 (US)
(74) Representative: Bowles, Sharon Margaret

(57) **Abstract**

A field effect transistor, either with or without a lightly doped N- drain, incorporates a relatively conductive deep P body contact source plug to reduce parasitic resistance underneath an N+ source region and to prevent a parasitic bipolar transistor from latching on when the voltage between the drain electrode and the P well changes rapidly. In a lightly doped drain an N+ source region extends into a P well from an upper surface of the P well and a N- drain region extends into the P well so that the N+ source region and the N- drain region are separated by a channel region. An N+ drain contact region extends into the lightly doped N- drain region to a depth less than the depth of the N- drain region so that a portion of the N- drain region separates the N+ drain contact region from the channel and from the underlying P well. A deep P body contact source plug region extends into the P well at a location underneath the source electrode so that the deep P body contact source plug region extends toward the channel region at least partly underneath the N+ source region. A gate insulating layer is disposed on the upper surface of the substrate over the channel region and a gate is disposed over the insulating layer so that the gate overlies the channel region.

## Description

### FIELD OF THE INVENTION

This invention relates to field effect transistors. More particularly, this invention relates especially to high power, high current, high switching speed N channel field effect transistors.

### BACKGROUND INFORMATION

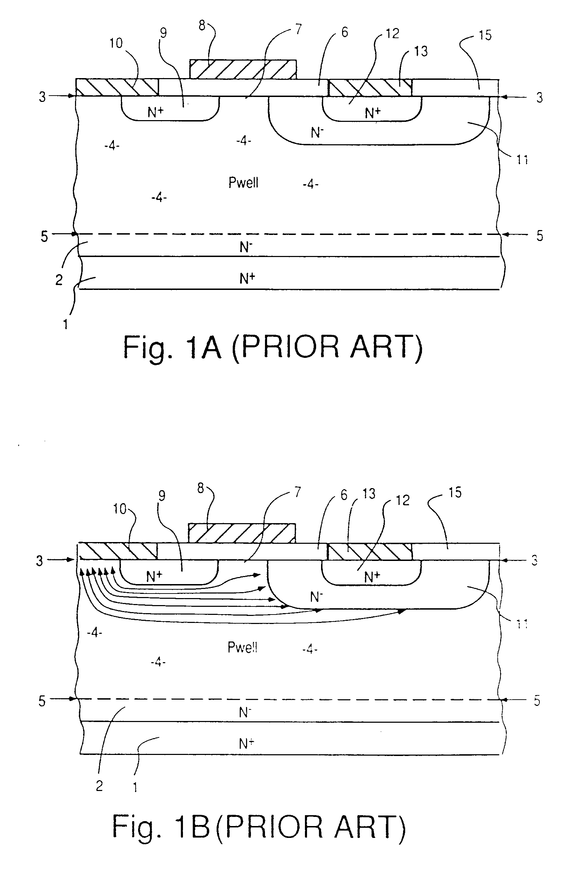

A lightly doped drain field effect transistor structure is conventionally used in high power switching applications. Figure 1A (Prior Art) shows such a conventional lightly doped drain N channel field effect transistor. In such a transistor, an N+ substrate 1 has an N- epitaxial layer 2 deposited upon it. The upper surface of the epitaxial layer 3 therefore becomes the upper surface of the resulting substrate. A P well 4 is diffused from the upper surface 3 of the substrate into the epitaxial layer to a depth shown as dotted line 5 in Figure 1A. An oxide is disposed on the upper surface of the substrate to form a gate oxide 6 and an isolating oxide 15. Gate oxide 6 is disposed over a channel region 7 and a gate 8 is disposed over the gate oxide 6 so that the gate overlies the channel region. A heavily doped N+ source region 9 extends into the P well from the upper surface of the substrate. This N+ source region 9 abuts the left side of the channel region 7 electrically connected to a source electrode 10. A shallow P+ region 16 abuts the left side of source region 9 to make contact with the underlying P well 4. A source electrode 10 is disposed on the upper surface of the substrate so as to be in electrical contact with the N+ source region 9 and with the P+ region 16. An N- lightly doped drain region 11 is also provided. This lightly doped N- drain region abuts the right side of the channel region 7 shown in Figure 1A so that the channel region 7 separates the N+ source region 9 from the N- drain region 11. A shallow N+ drain contact region 12 is formed inside the lightly doped N-drain region 11 to extend from the upper surface of the substrate into the epitaxial layer to a depth which is less than the depth of the N- drain region. A drain electrode 13 is disposed on the upper surface of the substrate to form an electrical contact with the highly doped N+ drain contact region 12.

In operation, the conventional lightly doped drain device of Figure 1A switches on when a inversion layer is formed in the channel region underneath the gate. Accordingly, a conduction path is formed from the drain electrode 13, to the N+ drain contact region 12, to the N-drain region 11, through the inversion layer in the channel region 7, to the N+ source region 9, and to the source electrode 10. In high voltage applications, if the lightly doped N- drain region 11 were not provided, a highly reverse biased junction would exist between the N+ drain contact region and the P well beneath it when the voltage on the N+ drain contact region has a large positive voltage with respect to the P well 4. In such situations, avalanche breakdown can occur in the depletion region of the reverse biased junction due to the high electric fields existing in the depletion region.

Accordingly, the lightly doped N- drain region 11 is provided between the more highly doped N+ drain contact region 12 and the P well 4. This lightly doped N- drain region forms a reverse biased junction with the P well, the depletion region of which has less severe electric fields at a given reverse bias voltage would be the case if the N- drain region were more highly doped. This lightly doped N- drain region therefor allows the resulting N channel field effect transistor structure to have a higher voltage breakdown tolerance than would be the case without the lightly doped drain region 11.

The conventional lightly doped drain structure of Figure 1A, however, has a drawback in high power fast switching applications. When the voltage on the drain electrode 13 with respect to the P well 4 increases or decreases rapidly, an amount of charge is either expelled from the silicon lattice where the depletion region grows or is reabsorbed back into the silicon lattice where the depletion region shrinks. The greater the expansion or contraction of the depletion region and the more rapid this expansion or contraction, the greater the magnitude of this transient movement of charge.

This transient movement of charge, commonly known as a displacement current, flows to and from the expanding and contracting depletion region between the lightly doped N- drain region 11 and the P well 4. As shown in Figure 1B (Prior Art) by arrows, this displacement current flows in a current path to or from the expanding or contracting depletion region between the lightly doped N- drain region 11 and the P well 4, through the portion of the P well region 4 underneath the lightly doped N- drain region 11, through the portion of the P well 4 underlying the channel region 7, through the portion of the P well 4 underlying the N+ source region 9, through the P+ region 16, and to or from the source electrode 10. Because the P well 4 has a resistance, the voltage in the P well along this current path varies. If the magnitude of the displacement current is great enough, the voltage in a portion of the P well directly underlying the N+ source region 9 will be .6 to .7 volts higher than the voltage of the N+ source region 9. The result is a forward biased PN base-emitter junction of a parasitic bipolar transistor. This parasitic transistor is formed from either the N-epitaxial layer underlying the P well, to the P well, to the N+ source region, or from the lightly doped N- drain region, to the P well, to the N+ source region. In both these cases, the P well is the base of the parasitic transistor and the N+ source region is the emitter. In one case, the N- epitaxial layer is the collector of the parasitic transistor. In the other case, the N-drain region is the collector. When this parasitic bipolar transistor turns on in situations of high displacement currents, the result may be a deleterious high current latchup situation due to interactions with other devices and layers which are not shown.

### SUMMARY OF THE INVENTION

The present invention is directed in part to solving the above described latchup problem associated with the parasitic bipolar transistor. The present invention is also directed to reducing the voltage along the displacement current path in a N channel transistor. This N channel transistor may have, in some embodiments, a lightly doped region. According to an N channel embodiment of the invention, a deep P body contact source plug region is provided in the displacement current path between the upper surface of the substrate underlying the source electrode. The deep P body contact source plug region extends downward into the P well and toward the channel region underneath at least a portion of the N+ source region. Because this deep P body contact region has a lower resistance than the lightly doped P well semiconductor material, the voltage generated underneath the N+ source region for a given displacement current will be less than would be the case without the deep P body contact region. Accordingly, the voltage on the base of the parasitic bipolar transistor will not become forwardly biased with respect to the N+ source region emitter as easily as would be the case if no deep P+ region were provided. The resulting structure of the present invention therefore is a more "rugged" N channel field effect transistor than is the conventionally known lightly doped drain device. The present invention is able to survive very high rates of change of voltage at the drain P well boundary without the device experiencing latchup.

### BRIEF DESCRIPTION OF THE DRAWINGS

Figure 1A (Prior Art) is a cross-sectional view of a conventional lightly doped drain N channel field effect transistor device.

Figure 1B (Prior Art) is a cross-sectional view of the flow of displacement current in the prior art lightly doped drain device of Figure 1A.

Figure 2 is a perspective view of one embodiment of the N channel field effect transistor of the present invention.

Figure 3A is a top-down view of one embodiment of the N channel field effect transistor of the present invention showing electrode metallization patterns.

Figure 3B is a cross-sectional view of one N channel field effect transistor of the present invention taken along sectional line A-A of Figure 3A.

Figure 3C is a cross-sectional view of the current path of the displacement current flowing in the present invention of Figures 3A-3B.

Figure 4A is a cross-sectional view of the doping density of the present invention taken along sectional line A-A of Figure 3A.

Figure 4B is a cross-sectional view of the vertical doping density of the present invention extending from the silicon surface into the silicon taken at Point B on Figure 3A.

Figure 4C is a cross-sectional view of the vertical doping density of the present invention extending from the silicon surface into the silicon taken at Point C on Figure 3A.

Figure 4D is a cross-sectional view of the vertical doping density of the present invention extending from the silicon surface into the silicon taken at Point D on Figure 3A.

Figure 4E is a cross-sectional view of the vertical doping density of the present invention extending from the silicon surface into the silicon taken at Point E on Figure 3A.

Figure 5 is a cross-sectional view of one N channel field effect transistor of the present invention comprising a heavily doped drain rather than a lightly doped, doubly diffused drain.

### DETAILED DESCRIPTION OF THE PREFERRED EMBODIMENT

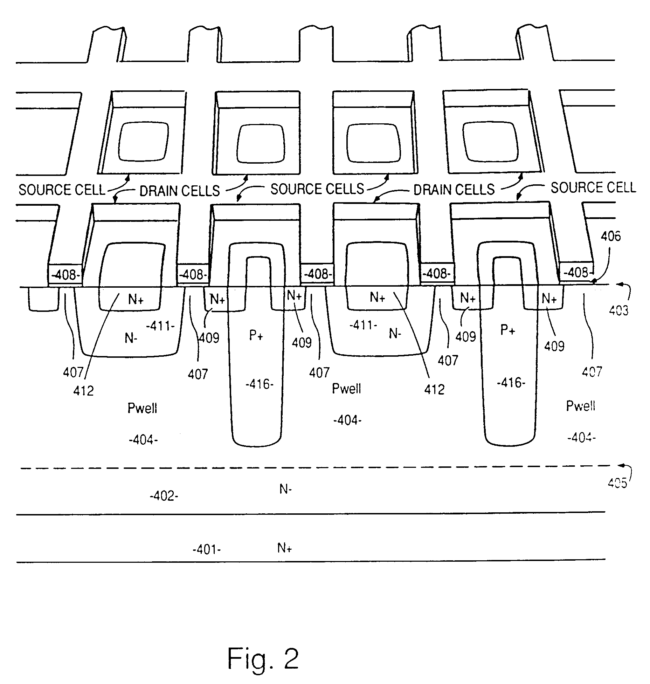

Figure 2 is a perspective view of a cross section of an embodiment of an N channel field effect transistor. Upon a heavily N+ doped substrate 401, is a lightly doped N- epitaxial layer 402. The upper surface of this epitaxial layer forms the upper surface 403 of the resulting substrate. A lightly doped P well region 404 is diffused into the epitaxial layer from the upper surface of the substrate to the dotted line 405 in Figure 2. Mesh-shaped gate insulating layer 406A is disposed on the upper surface of the substrate to overlie a mesh-shaped channel region 407 in the substrate at the upper surface 403 of the substrate. This gate insulating layer may be a deposited or grown layer of oxide. A mesh-shaped gate 408 is disposed on the upper surface of the gate insulating layer 406A so that the gate 408 overlies the channel region 407 in the underlying substrate. This gate 408 may, in some embodiments, comprise standard N+ doped polysilicon.

The mesh-shaped gate 408 sections the substrate into a two-dimensional array of cells. Alternating cells in each of the dimensions are source cells and drain cells so that the cells abutting each source cell in both of the two dimensions are drain cells and so that the cells abutting each drain cell in both of the dimensions are source cells. Each of the cells in the depicted embodiment have a square shape but any other suitable shape may be used such as triangles, pentagons, hexagons, circles or open-ended cells. In the case of open-ended cells, the width of each open-ended cell is much greater than the length of the open-ended cell in similar fashion to a standard MOS transistor layout. The cells need not necessarily be oriented in rows and columns, but rather may be oriented in any suitable matrix.

In each source cell, an annular N+ source region 409 extends from the upper surface 403 of the substrate and into the P well 404. In each drain cell an N- drain region 411 extends from the upper surface of the substrate and into the P well 404. In other lower voltage embodiments, N- region 411 can be eliminated and N+ region 412 extended laterally so that N+ region 412 extends to the lateral edges of N- region 411 in Figure 2. Each N+ source region 409 abuts the mesh-shaped channel region 407 and each N- drain region 411 abuts the channel region so that the mesh-shaped channel region 407 separates the N+ source regions from the N- drain regions. A shallow highly doped N+ drain contact region 412 extends from the upper surface 403 of the substrate into each of the N-drain regions. Each N+ drain contact region is disposed within a N- drain region so that a portion of the N- drain region separates the N+ drain contact region from both the channel and from the underlying P well. Although the bottom surfaces of the drain contact region 412 and of the lightly doped drain region 411 is shown to be flat and coplanar with top surface 403, other surface shapes may be used.

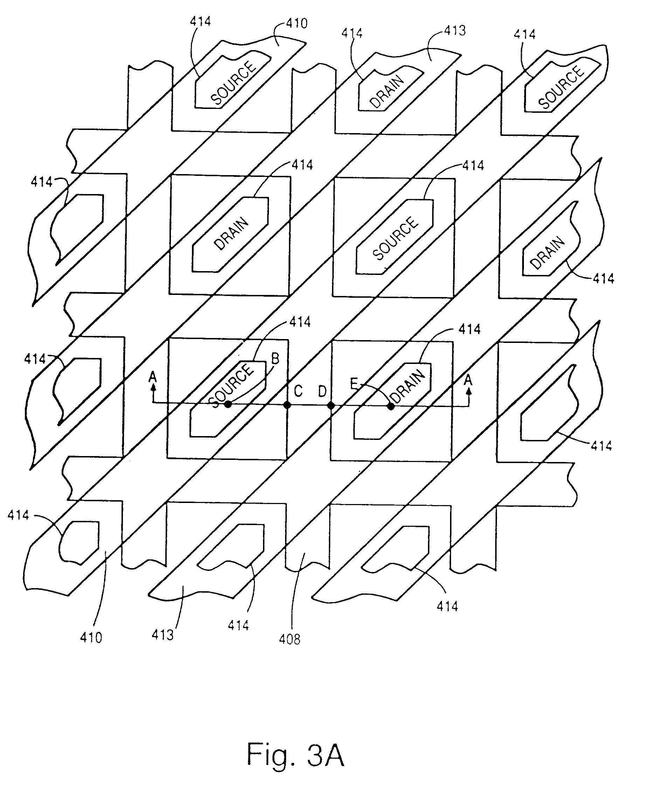

Figure 3A is a top down view of the N channel field effect transistor embodiment of Figure 2. The top down view of Figure 3A, however, shows source electrodes 410 and drain electrodes 413 overlying the structure shown in Figure 2. In Figure 3A, a layer of an insulator 406B such as silicon oxide is disposed over the structure of Figure 2 so that a series of contact windows 414 in the insulating layer 406B leave contact windows 414 exposing regions on the top surface 403 of each cell. Source electrodes 410 are disposed over the insulating layer 406B to overlay, at least partly, the N+ source region 409 of each source cell so as to make electrical contact with each individual N+ source region 409 through an individual contact window 414. Similarly, drain electrodes 413 are disposed over the insulating layer 406B to overlay, at least partly, the N+ drain contact region 412 of each drain cell to make electrical contact with each individual N+ drain contact region 412 through an individual contact window 414.

In the embodiment of Figure 3A, the source electrodes 410 and drain electrodes are interdigitated with one another and run diagonally across the two dimensional array of cells. These source electrodes and drain electrodes may, for example, be a series of strips as in Figure 3A, oriented in parallel and made of a metal such as aluminum.

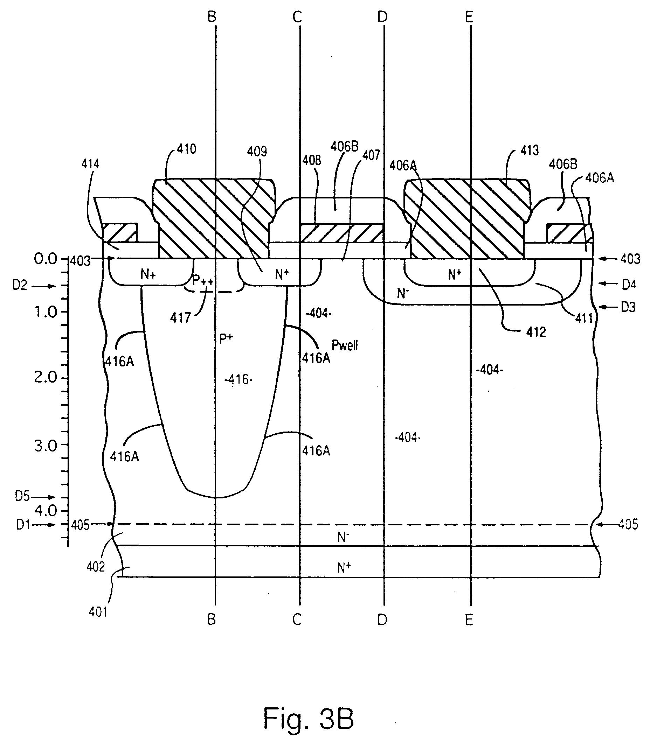

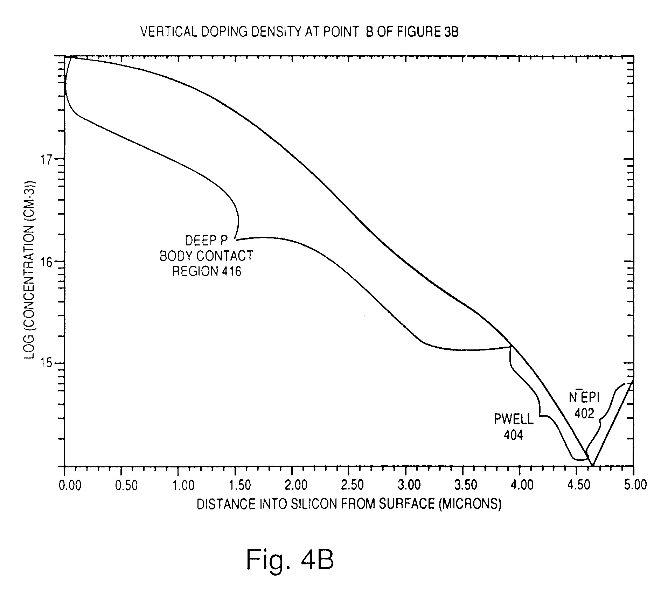

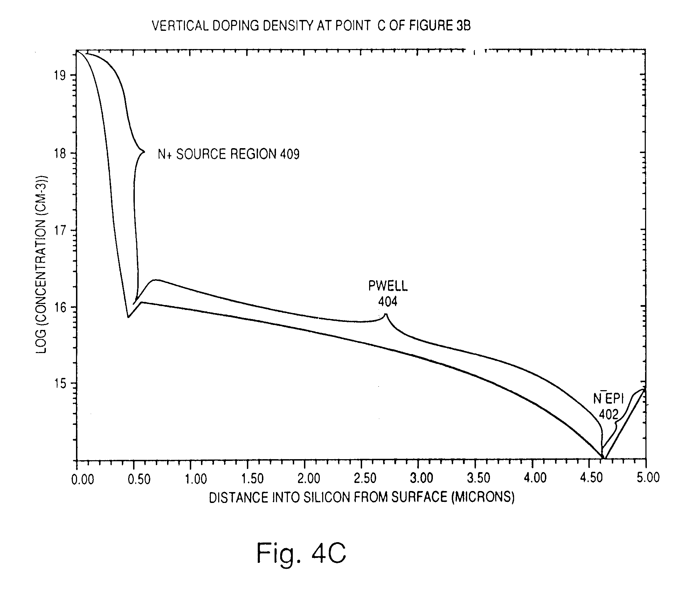

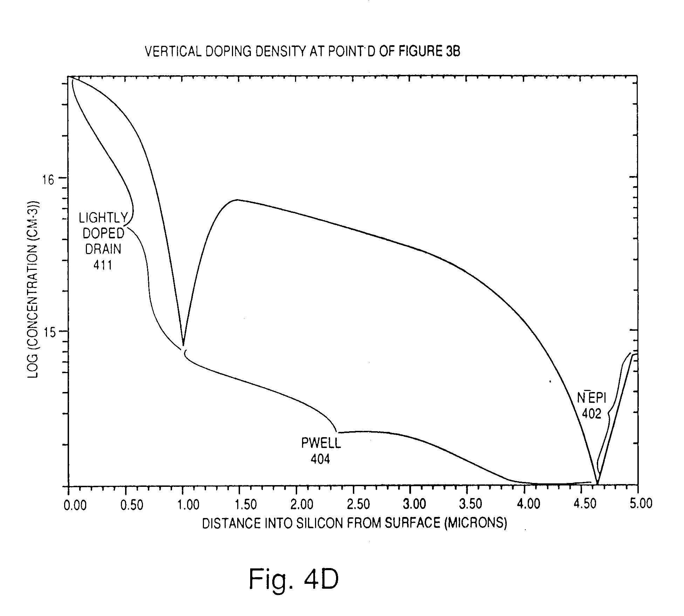

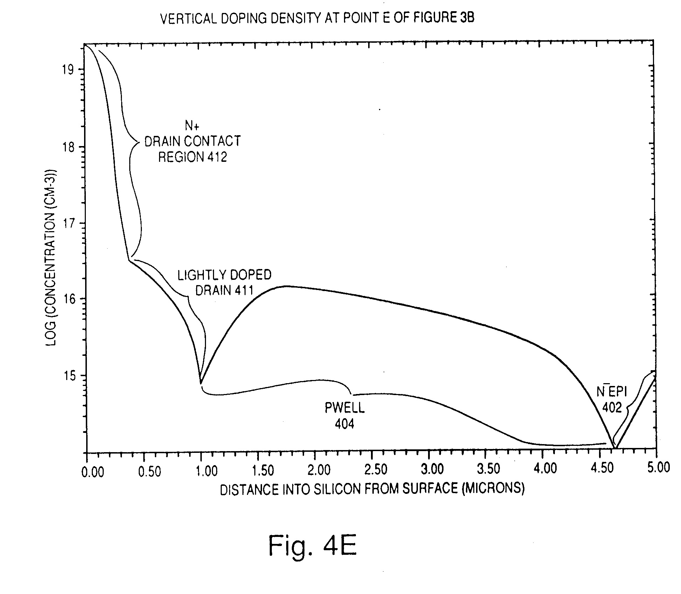

Figure 3B is a sectional view taken along line A-A of Figure 3A. Figure 3B shows a deep P body contact source plug region 416 extending from the upper surface 403 of the substrate from at least a location beneath the source electrode 410 into the P well 404. This deep P body contact source plug region 416 also extends laterally toward the channel region 407 at least partly underneath the N+ source region 409 shown in Figure 3B. Note that the source electrodes 410 make electrical contact with the top surface of each individual deep P body contact source plug region 416 in each source cell through an individual contact window. In some embodiments, a surface enhancement of the deep P body contact source plug region 416 may be present in the form of a shallow highly doped P++ contact diffusion 417.

The side surface 416A of the deep P body contact source plug region 416 which faces the channel region 407 and the N- drain region 411 extends substantially vertically from underneath the N+ source region. Accordingly, the distance of the current path through the P well 404 between the N- drain region 411 and the deep P body contact source plug region 416 in Figure 3B at a location directly underneath the N+ source region 409 will be substantially the same as the distance of the current path through the P well between the N- drain region and the deep P body contact source plug region 416 at a location on the side surface 416A facing the channel which is deeper in the substrate. The deep P body contact source plug is made to extend deep into the substrate so that displacement current will fan out in a vertical direction and flow deeper in the P well than would be the case with a more shallow deep P body contact source plug region. The deep P body contact source plug region 416 may, in some embodiments, extend toward the channel region under the full extent of the N+ source region 409. The proportion of the N+ source region which is underlain by the deep P body contact source plug region is a matter of design choice. In the embodiment of Figure 3B, the deep P body contact source plug region 416 extends under half of the lateral extent of the N+ source region 409.

In some embodiments, the N+ source region 409 and the N- drain region 411 are self aligned with the gate 408. In these embodiments, the gate is deposited on the insulating layer and is then used as a mask for a subsequent implantation step. N type dopants for the N+ source region and the N- drain region are implanted into the upper surface of the substrate with the gate defining the implant boundaries. A subsequent heat driving step diffuses the implanted dopants of the source region and drain region downward into the P well and laterally towards each other so that both the source region 409 and the drain region 411 extend for a distance underneath the gate.

The N+ drain contact region 412 may in some embodiments be diffused through and etched hole in the insulating layer 406B or in the gate insulating oxide 406A. Similarly, the deep P body contact source plug region 416 may be diffused through an etched hole in the insulating layer 406B or in the gate insulating oxide 406A.

As can be seen from Figure 3B, depth D1 of the P well is 4.2 microns, depth D2 of the source region 409 is .4 microns, depth D3 of the lightly doped drain region 411 is .9 microns, depth D4 of the drain contact region 412 is .4 microns, and depth D5 of the deep P body contact source plug region 416 is 3.8 microns. The gate in the embodiment shown in Figure 3B is 3.5 microns wide due to photolithographic limitations of the mask exposure system used. There is indication that gate width may be reduced to 2 microns without seriously impacting the ultimate breakdown voltage of this device. The P well 404 as shown in Figure 3B is 4.2 microns deep, but may vary in depth from a few microns to well over 5 microns for practical usage.

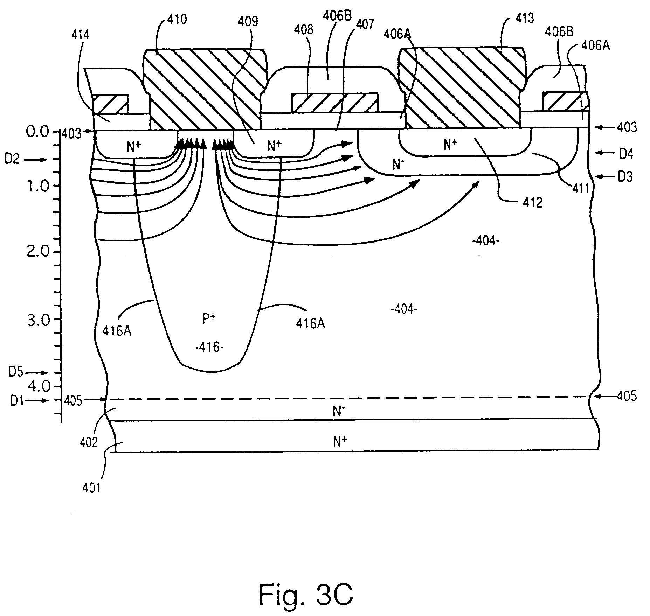

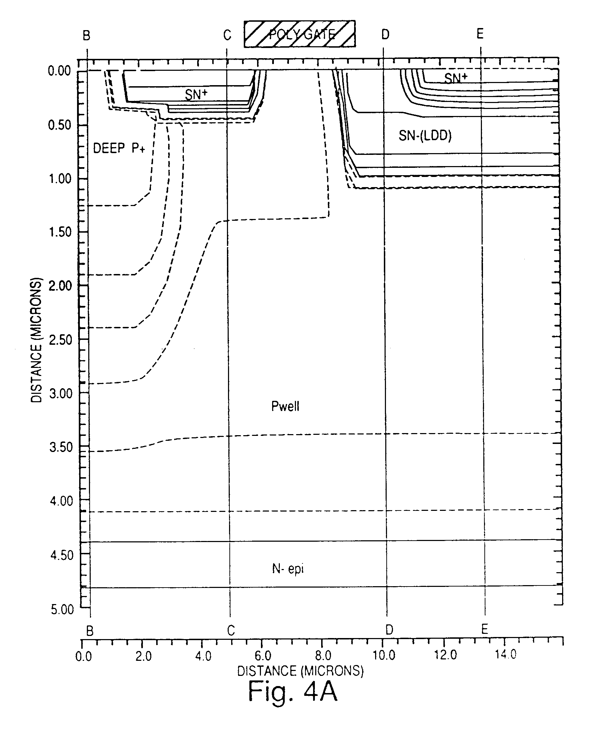

Figure 3C is a cross sectional view taken along line A-A in Figure 3A showing the flow of displacement current back and forth from the depletion region between the lightly doped drain region 411 and the P well 404, through the P well 404, through the deep P body contact source plug region 416, and to or from the source electrode 410 disposed on the upper surface 403 of the substrate. Displacement current flow in the conventional device of Figures 1A-1B is confirmed to a relatively shallow region of the P well 4, whereas displacement current flow in the present invention flows deeper in the substrate due to the deep P body contact source plug region 416. A good deep P+ region should be approximately 3.5 microns deep and have a sheet resistance of about 100 ohms per square. Generally this can be implanted or diffused and then driven to its proper depth by a thermal cycle. There is nothing critical in the production of the deep P+ plug. A window between 3 and 4 microns may be opened for a diffusion or an implant.

Figure 4A is a cross-sectional view showing the approximate doping density along the cross-sectional line A-A of Figure 3A. Vertical lines B-B, C-C, D-D and E-E in Figures 4A-4E correspond with points B-E along sectional line A-A in Figure 3A. Each line in Figure 4A is meant to represent a ten fold increase or decrease in doping density. Figure 4A shows a very gradual increase in doping concentration from the P well under the N+ source region into the deep P body contact region. Figures 4B-4E disclose the doping concentration extending vertically into the substrate from surface 403 at points B-E along line A-A of Figure 3A when an optional P++ region 417 is not provided.

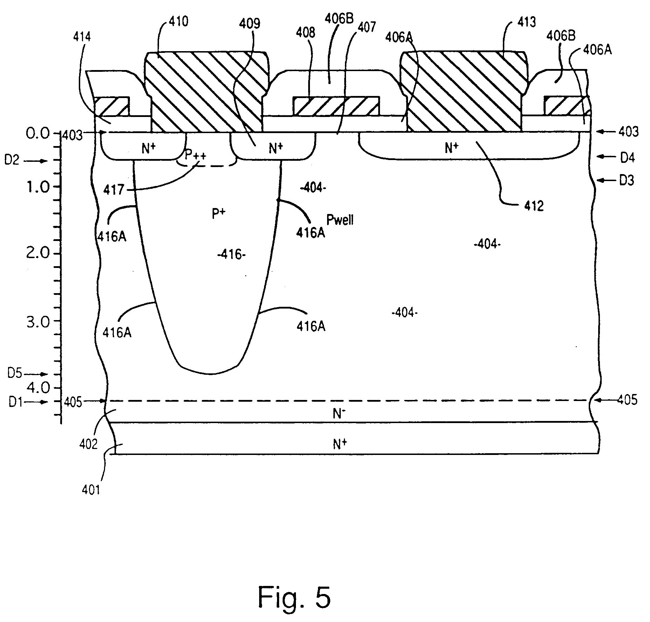

While the above-described embodiments incorporate a double diffused drain with a lightly doped region 411 and a more highly doped region 412, other embodiments utilize a deep P body contact source plug region 416 without a double diffused drain structure. In one such embodiment shown in Figure 5, no lightly doped drain region is N+ region 412. Rather, N+ region 412 is made to extend laterally under gate 408 to the lateral extent of the N-region 411 of Figure 3B . Although this relatively heavily doped drain embodiment will generally have a lower breakdown voltage than the above described doubly diffused drain embodiments, this heavily doped drain embodiment nevertheless will have favorable high speed switching characteristics due to the deep P region 416.

Because various devices described above are capable of high speed and high voltage switching without suffering latchup, they are suitable for use in switching regulators with high edge rates, in motion control circuitry used to control disk drives, in circuitry for driving inductive coils of motors in disk drives, and in circuitry for driving inductive read/write heads in disk drives. In situations in which the invention is to drive an inductive load, such as in a motor or read/write head, rapidly cutting off the current flow to the inductance results in a very fast and extremely large voltage spike being generated by the inductor. Due to the structure of the field effect transistor of the present invention, the drain of the present invention is able to be connected substantially directly to the inductor to switch inductor current on and off rapidly without experiencing the deleterious effects of latchup inside the field effect transistor.

Although specific embodiments are described in the foregoing disclosure, multiple adaptations to other semiconductor technologies as well as other embodiments are within the scope of the invention as defined by the following claims. For example, a P channel device is realized when all P type regions become N type regions and visa versa. The separately diffused P well can be eliminated so that a P type epitaxial layer serves as the P well in a N channel device. Similarly, the separately diffused N well in a P channel device can be eliminated so that a N type epitaxial layer serves as the N well. Accordingly, this description is to be construed as illustrative. Specifics of the embodiments described above are therefore not intended to limit the scope of the invention as set forth in the appended claims.

## Claims

1. A field effect transistor comprising:
a semiconductor body of a first conductivity type having an upper surface;
a gate insulating layer disposed on said upper surface and overlying a channel region located in said body at said upper surface;
a gate, disposed on said gate insulating layer and overlying said channel region;
a lightly doped drain region of a second conductivity type disposed in said body and abutting said channel region, said lightly doped drain region extending into said body from said upper surface to a first depth;
a drain contact region disposed in said body and separated from said channel region by a portion of said lightly doped drain region, said drain contact region extending into said lightly doped drain region from said upper surface to a second depth smaller than said first depth;
a source region disposed in said body and extending from said upper surface into said body to a third depth, said source region abutting said channel region; and
a deep body contact region of said first conductivity type disposed in said body and extending into said body to a fourth depth, a portion of said deep body contact region extending underneath at least a part of said source region.

2. The field effect transistor of Claim 1, wherein said deep body contact region does not abut said channel region.

3. The field effect transistor of Claim 1, wherein said fourth depth is greater than said first depth.

4. The field effect transistor of Claim 1, wherein said deep body contact region is formed by diffusion.

5. The field effect transistor of Claim 1, wherein said deep body contact region has a substantially vertical side surface which faces the channel region and the lightly doped drain region.

6. The field effect transistor of Claim 1, wherein said deep body contact region has a side surface which faces the lightly doped drain region, and wherein the lightly doped drain region has a side surface which faces the deep body contact region, said deep body contact region being disposed so that said side surface of said deep body contact region is substantially equidistant from said side surface of said lightly doped drain region over an area of said side surface of said deep body contact region.

7. The field effect transistor of Claim 1, wherein said gate comprises polysilicon.

8. The field effect transistor of Claim 1, wherein said gate functions as a mask when dopants are implanted to form said source region and said lightly doped drain region, said source and lightly doped drain regions being self aligned with said gate.

9. The field effect transistor of Claim 8, wherein said dopants are diffused toward each other after being implanted, said lightly doped drain region extending a distance underneath said gate and said source extending a distance underneath said gate.

10. The field effect transistor of Claim 1, wherein an epitaxial layer is disposed over a bulk region, said epitaxial layer being comprised of a lightly doped semiconductor material of said second conductivity type, said body being a well region diffused from said upper surface into said epitaxial layer.

11. The field effect transistor of Claim 10, wherein said epitaxial layer extends from said upper surface into said substrate to a fifth depth, said well region being diffused into epitaxial layer to a sixth depth, said sixth depth being smaller than said fifth depth.

12. The field effect transistor of Claim 1, further comprising:
a source electrode disposed over said upper surface, said source electrode being in contact with said source region; and
a drain electrode disposed over said upper surface, said drain electrode being in contact with said drain contact region.

13. The field effect transistor of Claim 1, wherein said semiconductor material of said first conductivity type is P type silicon, and wherein said semiconductor material of said second conductivity type is N type silicon.

14. The field effect transistor of Claim 1, wherein said body is an epitaxial layer disposed on a substrate.

15. A method of preventing a parasitic bipolar transistor from turning on in a field effect transistor, said field effect transistor having a drain contact region and a source region separated at least in part by a channel region, said drain contact region and said source region extending into a lightly doped well region of semiconductor material of a first conductivity type, said source region and said drain contact region comprising a semiconductor material of a second conductivity type, comprising the steps of:
providing a shallow lightly doped drain region underneath said drain contact region and between said drain contact region and said channel region, said shallow lightly doped drain region being comprised of a lightly doped semiconductor material of said second conductivity type; and
providing a deep body region underneath at least a portion of said source region, said deep body region being comprised of a semiconductor material of said first conductivity type.

16. The method of Claim 15, wherein said deep body region does not abut said channel region.

17. The method of Claim 15, wherein said well region of semiconductor material of a first conductivity type has an upper surface, and wherein said deep body region extends into said well region from said upper surface to a first depth, and wherein said shallow lightly doped drain region extends into said well region from said upper surface to a second depth, said first depth being greater than said second depth.

18. The method of Claim 17, wherein said semi-conductor material of said first conductivity type is P type silicon, and wherein said semiconductor material of said second conductivity type is N type silicon.

19. The method of Claim 18, wherein said step of providing said deep body region comprises a diffusion step.

20. The method of Claim 15, further comprising the steps of:
forming a gate insulating layer over said channel region on said upper surface of said well region;
forming a gate on said gate insulating layer; and
using said gate as a mask during a self-aligning implanting step wherein dopants are implanted in said upper surface of said well region to form said source region and said shallow lightly doped region so that said source region and said shallow lightly doped drain region are self-aligned with said gate.

21. A power field effect transistor device, comprising:
a mesh-shaped gate defining a plurality of cell regions in an underlying semiconductor material, each of said plurality of cell regions extending from an upper surface of said semiconductor material;
a plurality of deep P source plug regions, one of said plurality of deep P source plug regions being disposed in each of alternate ones of said plurality of cell regions;
a plurality of annular N source regions, one of said plurality of annular N source regions being disposed in each of said alternate ones of said plurality of cell regions;
a plurality of relatively lightly doped N drain regions, one of said plurality of relatively lightly doped N drain regions being disposed in each of said cell regions other than said alternate ones;
a plurality of relatively highly doped N drain contact regions, one of said plurality of relatively highly doped N drain contact regions being disposed in each of said cell regions other than said alternate ones;
an insulating layer overlying at least part of said mesh-shaped gate;
a source electrode connecting said plurality of annular N source regions and said plurality of deep P source plug regions through first contact windows in said insulating layer; and
a drain electrode connecting said plurality of relatively lightly doped N drain regions through second contact windows in said insulating layer.

22. The power field effect transistor device of Claim 21, wherein said cell regions have a polygonal shape.

23. The power field effect transistor device of Claim 22, wherein said deep P source plug regions extend into said semiconductor material to a first depth, and wherein said relatively lightly doped N drain regions extend into said semiconductor material to a second depth, said first depth being deeper than said second depth.

24. In a transistor having a channel disposed between a drain and a source, a method of reducing a magnitude of a voltage produced by a displacement current, said displacement current flowing in a current path to or from a PN junction between said drain and a substrate, said method comprising the step of:
disposing an amount of low resistance semiconductor material in said current path and outside said channel, said low resistance semiconductor material having a resistance lower than a resistance of a semiconductor material comprising said substrate.

25. The method of Claim 24, wherein said low resistance semiconductor material is disposed to be separated from said junction.

26. The method of Claim 25, wherein said low resistance semiconductor material is disposed to contact said source.

27. The method of Claim 26, wherein said transistor comprises a source electrode, wherein said displacement current flows to or form said source electrode, and wherein said low resistance semiconductor material is disposed to contact said source electrode.

28. The method of Claim 27, wherein said source has an annular shape and wherein said drain surrounds said source.

29. A field effect transistor comprising:
a substrate having an upper surface;
a well region, disposed in said substrate, said well region being comprised of a lightly doped semiconductor material of a first conductivity type;
a gate insulating layer disposed on said upper surface, said gate insulating layer overlying a channel region, said channel region being located in said substrate at said upper surface;
a gate, disposed on said gate insulating layer, said gate overlying said channel region;
a drain region comprised of a semiconductor material of a second conductivity type, said drain region abutting said channel region, said drain region extending into said well region from said upper surface to a first depth;
a source region comprised of a semiconductor material of said second conductivity type, said source region extending from said upper surface into said well region to a second depth, said source region abutting said channel region; and
a deep body contact region comprised of a semi-conductor material of said first conductivity type, said deep body contact region extending into said well region to a third depth, a portion of said deep body contact region extending underneath at least a part of said source region, said third depth being greater than said first and second depths.

30. The field effect transistor of Claim 29, wherein said deep body contact region does not abut said channel region.

31. The field effect transistor of Claim 29, wherein said deep body contact region has a substantially vertical side surface which faces the channel region and the drain region.

32. The field effect transistor of Claim 29, wherein said deep body contact region has a side surface which faces the drain region, and wherein the drain region has a side surface which faces the deep body contact region, said deep body contact region being disposed so that said side surface of said deep body contact region is substantially equidistant from said side surface of said drain region over an area of said side surface of said deep body contact region.

33. The field effect transistor of Claim 29, wherein said gate functions as a mask when dopants are implanted to form said source region and said drain region, said source and drain regions being self aligned with said gate.
